Europäisches Patentamt

European Patent Office

Office européen des brevets

(11) Veröffentlichungsnummer: **0 514 689 A1**

# EUROPÄISCHE PATENTANMELDUNG

(21) Anmeldenummer: **92107230.2**

(22) Anmeldetag: **28.04.92**

(51) Int. Cl.5: **H03K 17/968**, H01H 35/02

(30) Priorität: **21.05.91 DE 9106217 U**

(43) Veröffentlichungstag der Anmeldung:
**25.11.92 Patentblatt 92/48**

(84) Benannte Vertragsstaaten:
**AT BE CH DE DK FR GB IT LI NL SE**

(71) Anmelder: **Nokia (Deutschland) GmbH**
**Östliche Karl-Friedrich-Strasse 132**
**W-7530 Pforzheim(DE)**

(72) Erfinder: **Durst, Klaus**
**Odenwaldstrasse 15**
**W-7520 Bruchsal 7(DE)**

(54) **Kugelschalter zur signalmässigen Kennzeichnung von auswählbaren Neigungsrichtungen einer Basisebene.**

(57) Die als Basisebene (5) dienende Innenseite des Bodens (10) des Kugelführungsgehäuses (1) eines Kugelschalters enthält zur Bildung einer Basislagerstelle (4) eine pyramidenförmige Vertiefung (8) für die Basislagerung einer Schaltkugel (3) in einer (waagerechten) Normlage des Kugelschalters. Die Basislagerstelle wird zur Definition eines bestimmten Auskippwinkels (a) der Schaltkugel durch eine kreisscheibenförmige Vertiefung (11) im Bereich der Pyramidenspitze (9) gebildet. Die Lichtsenderelemente (16) und Lichtempfängerelemente (17) sind in lichtdichten Kammern (15) hinter Seitenwänden (14) des Innenraumes (6) des Kugelführungsgehäuses angeordnet und lichtmäßig über Bohrungen (20) und daran anschließende, in den Seitenwänden (14) enthaltenen rotationssymmetrischen, sich zur Kammer hin verengenden Vertiefungen (21) mit dem Innenraum verbunden. Die Vertiefungen sind so ausgebildet, daß sie bei der entsprechenden Neigungslage mit der an der Innenwand (28) der Vertiefung anliegenden Schaltkugel einen lichtdicht abschließenden Kanal bilden.

Fig. 2

EP 0 514 689 A1

Die Erfindung betrifft einen Kugelschalter zur signalmäßigen Kennzeichnung von auswählbaren Neigungsrichtungen einer Basisebene einer im Oberbegriff des Anspruches 1 angegebenen Art.

Derartige von der Schwerkraft abhängige Schalter beziehen sich auf die Schwerkraft und kennzeichnen eine Ablage einer Basisebene von einer bestimmten Lage dieser Ebene zur Schwerkraft in einer bestimmten Richtung. Die bestimmte, auf die Schwerkraft bezogene Lage der Basisebene ist die Ruhelage der Basisebene. Mittels derartiger Kugelschalter werden Ablagen eines Gegenstandes von einer Ruhelage oder einer Arbeitsstellung signalisiert oder es werden damit lage- oder stellungsabhängige Schalt- oder Steuerbefehle erzeugt. So ist es beispielsweise aus der DE-Gebrauchsmusterschrift 898132.3 bekannt, in beweglichen Geräten oder Geräteteilen, insbesondere Heizlüftern, Bügeleisen und dergleichen einen derartigen Kugelschalter anzuordnen, der die Arbeitsstellung der Geräte feststellt und bei einer Lage der Geräte außerhalb der Arbeitslage die Stromzuführung unterbricht.

Aus der französischen Patentanmeldung Nr. 1.504.706 ist ein mechanischer Kugelschalter mit mehreren Lagerstellen für eine Schaltkugel bekannt, die an den einzelnen Lagerstellen durch ihr Gewicht mechanische Schalter schließt. Damit können abhängig von der Stellung des Kugelschalters unterschiedliche Funktionen geschaltet werden. Für diese Schaltfunktion ist jedoch ein verhältnismäßig hohes Gewicht der Schaltkugel erforderlich, was eine verhältnismäßig große Schaltkugel bedingt. Außerdem wird die Schaltkugel in einem verhältnismäßig langen Rohr in Richtung der Schwerkraft in ihrer Schalterposition gehalten. Zur Einstellung bestimmter Steuerbefehle sind bei dem in der genannten Druckschrift dargestellten Kugelschalter bestimmte, von der äußeren Form des Kugelführungsgehäuses des Kugelschalters bestimmte Stellungen des Kugelschalters auszuwählen.

Mit einem aus der DE-Offenlegungsschrift 3924551 vorgeschlagenen Kugelschalter der Anmelderin ist es möglich, bestimmte auswählbare Stellungen des Kugelschalters einzustellen. Aufgrund der Ausbildung des Kugelführungsgehäuses des Kugelschalters kann die Schaltkugel innerhalb des Gehäuses nur einige wenige Ruhe- oder Endlagerstellen einnehmen. Zwischenstellungen sind darin nicht möglich. Dies wird durch besondere Führungselemente im Kugelführungsgehäuse dieses Kugelschalters erreicht, nämlich einmal durch eine pyramidenförmige Vertiefung in der Basisebene des Kugelführungsgehäuses und durch eine besondere Ausbildung der aus der Basisebene herauswachsenden Seitenwände im Inneren des Kugelführungsgehäuses. Diese Seitenwände sind so ausgebildet, daß sie keine latenten Auflagerungen der Schaltkugel zwischen zwei Endlagerstellen der Schaltkugel zuläßt und die Schaltkugel immer in eine der Endlagerstellen ableitet.

Der Erfindung liegt die Aufgabe zugrunde, ein Kugelführungsgehäuse der zuletzt genannten Art derart weiterzubilden, daß auch bei der Verwendung einer verhältnismäßig kleinen Schaltkugel (beispielsweise bei einem Durchmesser unter 3mm) an den Endlagerstellen eine Abdichtung der Lichtaustritts- oder Lichteintrittsöffnung durch die Schaltkugel von hoher Lichtdichte bei schon verhältnismäßig geringen Neigungswinkeln hergestellt wird.

Diese Aufgabe wird nach der Erfindung durch die im kennzeichnenden Teil des Anspruches 1 angegebenen Merkmale gelöst.

Die Verwendung der bekannten Kugelschalter hat gezeigt, daß sich insbesondere das Infrarotlicht in derartigen Kugelführungsgehäusen auch in engen, verwinkelten Räumen intensiv und gleichmäßig ausbreitet, so daß weniger dicht abgedeckte Lichtdurchführungen noch relativ viel Infrarotlicht durchlassen und dadurch das Schaltverhalten eines derartigen lichtelektrischen Kugelschalters wesentlich einschränken. Dieses eingeschränkte Schaltverhalten kann so weit gehen, daß die Schaltunterschiede in den Bereich der industriellen Bauelementestreuung der verwendeten Lichtelemente gelangen. Der Einschluß der Lichtelemente in getrennte Kammern, die erfindungsgemäße Lichtführung aus oder in die Kammern und die erfindungsgemäße Auflagerung der Schaltkugel in den Endlagestellungen der Schaltkugel ermöglichen eine so lichtdichte Abdeckung der Lichtdurchlässe in die oder aus den Kammern der Lichtelemente, daß selbst bei sehr geringem Anlagedruck der Schaltkugel auf die Auflagerstelle ein nur unwesentlicher Lichtanteil die Auflagerstelle durchdringt. Trotz dieser verhältnismäßig hohen Lichtabdichtung ist ein derartiges Kugelführungsgehäuse als zweiteiliges Preßteil einfach und billig herzustellen und zu bestücken.

Die Unteransprüche kennzeichnen vorteilhafte Ausgestaltungen der Erfindung. Besonders vorteilhaft ist es, sowohl den Boden als auch den Deckel des Kugelführungsgehäuses mit einer Basisebene auszustatten und in jeder dieser Basisebenen eine pyramidenförmige Vertiefung anzuordnen. Dadurch kann der Kugelschalter in zwei Lagen, beispielsweise in einer hängenden oder in einer aufliegenden Lage verwendet werden.

Die Erfindung wird nachfolgend anhand vorteilhafter Ausführungsbeispiele näher erläutert. In den zugehörigen Zeichnungen zeigen

Fig. 1      eine vereinfachte perspektivische Darstellung eines geöffneten, bestückten Kugelführungsgehäuses eines Kugelschalters;

Fig. 2     eine Seitenansicht eines längsgeschnittenen Kugelschalters in nach links unten geneigter Lage;

Fig. 3     eine Draufsicht auf die Basisebene und die darin enthaltene pyramidenförmige Vertiefung eines Ausschnittes aus einem in Figur 2 dargestellten Kugelführungsgehäuse.

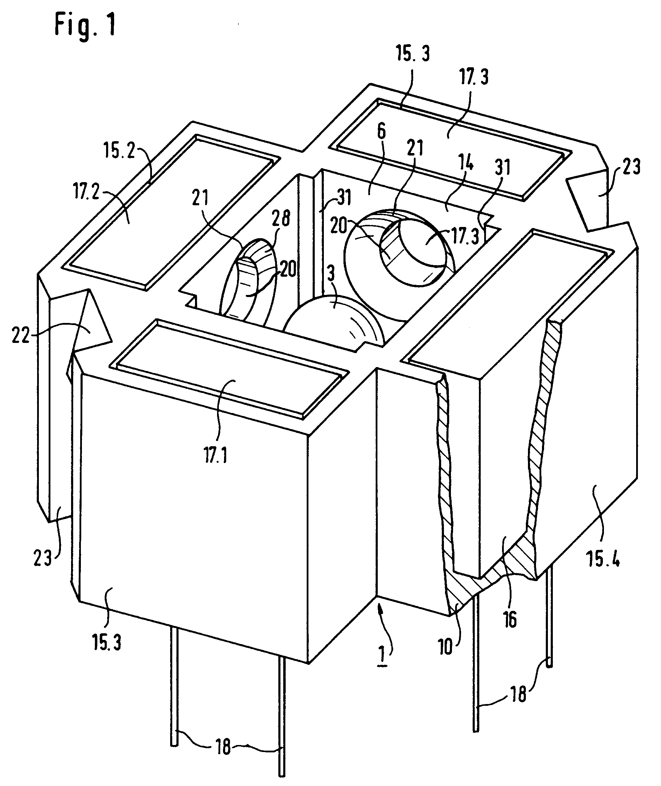

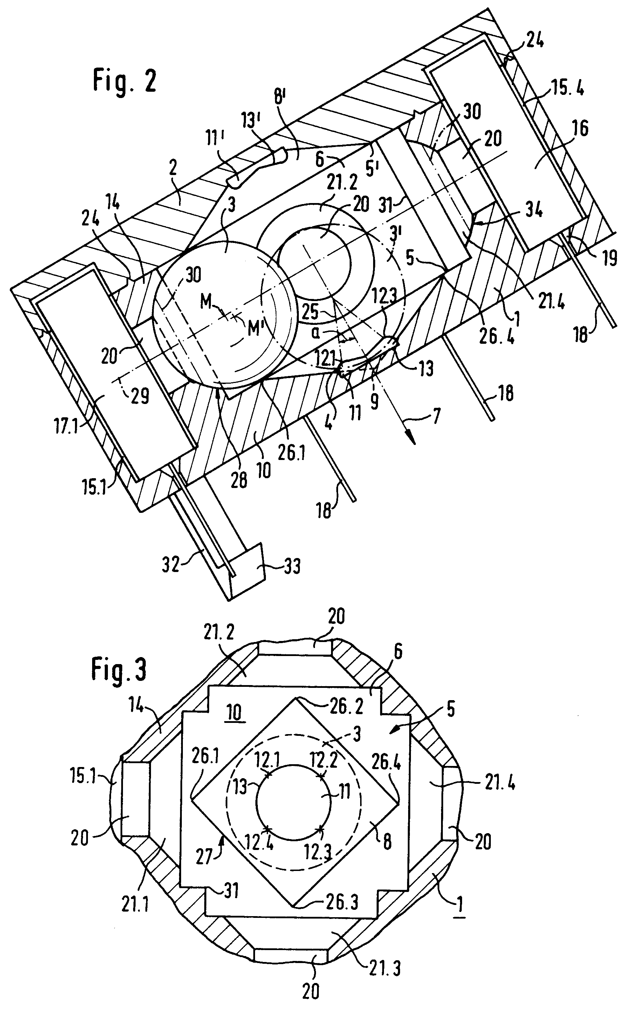

In Figur 1 ist in einer perspektivischen Darstellung vereinfacht ein Kugelschalter dargestellt, von dessen Kugelführungsgehäuse 1 der Deckel abgenommen und nicht näher dargestellt ist. In Figur 2 hingegen ist die Seitenansicht eines Schnittes längs einer senkrechten Ebene durch eine Symmetrieachse 29 des in Figur 2 dargestellten Kugelschalters mit dem zugehörigen, auf das Kugelführungsgehäuse 1 aufgesetzten Deckel 2 dargestellt. Der Kugelschalter enthält als Schaltelement eine Kugel, hier als Schaltkugel 3 bezeichnet, die in dem in Figur 1 dargestellten Ausführungsbeispiel auf einer Basislagerstelle 4 (Fig. 2) lagert. Das Kugelführungsgehäuse 1 weist eine Basisebene 5 auf, die den Boden 10 des Innenraumes 6 des Kugelführungsgehäuses 1 bildet und die in der Normallage des Kugelschalters senkrecht zur Schwerkraft 7 angeordnet ist. In den Boden des Kugelführungsgehäuses ist eine pyramidenförmige Vertiefung 8 eingelassen, deren Pyramidenspitze 9 in der Normallage des Kugelschalters in die Richtung der Schwerkraft 7 weist. Im Bereich der Pyramidenspitze enthält der Boden 10 des Kugelführungsgehäuses 1 eine weitere Vertiefung in der Gestalt einer kreisrunden Ausnehmung 11, deren Rand mit der Pyramidenwand die Basislagerstelle 4 bildet. In dem in Figur 3 dargestellten Ausschnitt aus dem in Figur 2 dargestellten Kugelführungsgehäuse ist die Basisebene 5 als Begrenzung des Bodens des Kugelführungsgehäuses zum Innenraum 6 des Kugelführungsgehäuses 1 zu sehen, in dem die pyramidenförmige Vertiefung 8 und die daran anschließende Ausnehmung 11 eingelassen ist. Dort sind auch die Auflagerpunkte 12 der Schaltkugel 3 auf dem inneren Rand 13 der pyramidenförmigen Vertiefung eingezeichnet. Diese vier Punkte 12.1 bis 12.4 bilden die Basislagerstelle 4 für die Schaltkugel in der Mitte des Kugelführungsgehäuses 1.

Der Innenraum 6 des Kugelführungsgehäuses ist im dargestellten Ausführungsbeispiel von vier Seitenwänden 14 begrenzt, die senkrecht aus der Basisebene 5 ansteigen und an die außen je eine Kammer 15 zur Aufnahme eines Lichtsenderelementes 16 oder eines Lichtempfängerelementes 17 angebracht ist. Die Anschlußdrähte 18 der Lichtsender- und Lichtempfängerelemente 16 und 17 sind durch Bohrungen 19 im Boden 10 des Kugelführungsgehäuses 1 hindurchgeführt. Zur Lichtleitung von der Kammer in den Innenraum 6 des Kugelführungsgehäuses oder umgekehrt ist in den Seitenwänden 14 von jeder Kammer 15.1 bis 15.4 zum Innenraum 6 des Kugelführungsgehäuses eine Bohrung 20 durch die Seitenwand 14 zwischen der Kammer 15 und dem Innenraum des Kugelführungsgehäuses angebracht, die in den Grund einer rotationssymmetrischen, sich zum Grund hin verengenden, innenraumseitigen Vertiefung 21 mündet. Als besonders vorteilhafte Ausbildungen ist in dem in Figur 2 dargestellten Ausfüh-rungsbeispiel die linksseitig dargestellte rotations-symmetrische Vertiefung 21.1 trichterförmig ausgebildet und als mögliche weitere Ausbildung die rechtsseitig dargestellte rotationssymmetrische Vertiefung 21.4 in der Gestalt einer Kugelteilschale ausgebildet.

Der Deckel 2 des Kugelführungsgehäuses 1 wird im dargestellten Ausführungsbeispiel mittels Snap-Elementen am Kugelführungsgehäuse befestigt und gehalten. Von diesen Snap-Elementen sind in Figur 2 die von federnden Rasthaken des Deckels hintergreifbaren Vorsprünge 22 zwischen Führungswänden 23 am Kugelführungsgehäuse 1 schematisch dargestellt. In Figur 2 sind zwischen dem Deckel 2 und dem Kugelführungsgehäuse 1 außerdem Falzungen 24 angedeutet, die der Lichtabdichtung zwischen dem Deckel 2 und dem Kugelführungsgehäuse dienen.

Der Kippwinkel a der Schaltkugel 3' aus der Basislagerstelle 4 ist der Winkel, den die Projektion 25 des Kugelradius auf einen der Auflagerpunkte 12 der Basislagerstelle 4 aus der in Figur 2 dargestellten Seitenansicht mit der Schwerkraft 7 in der Normallage des Kugelschalters bildet. Überschreitet die Neigung des Kugelschalters diesen Kippwinkel, kippt die Schaltkugel 3' aus der Basislagerstelle 4 in die am weitesten nach unten geneigte Richtung und rollt auf zwei benachbarten Wänden der pyramidenförmigen Vertiefung auf die am tiefsten liegenden Ecke 26 des von der pyramidenförmigen Vertiefung mit der Basisebene gebildeten Basislinienpolygons 27 zu. Der Winkel der Seitenwände der pyramidenförmgigen Vertiefung 8 mit der Basisebene 5 ist so bemessen, daß die Schaltkugel beim Auskippen aus der Basislagerstelle bereits auf eine leicht abschüssige Rollbahn fällt. Sobald die Schaltkugel 3 am Basislinienpolygom 27 auf den Rand der Basisebene aufläuft, rollt sie mit einem erhöhten Gefälle auf dem Basislinienpolygon der in Rollrichtung liegenden Ecke zu, bis sie vor Erreichen dieser Ecke an der Innenwand der rotationssymmetrischen Vertiefung 21 in der nächstliegenden Seitenwand 14.1 des Kugelfüh-rungsgehäuses anschlägt. Die rotationssymmetri-sche Vertiefung 21 in der Seitenwand 14 ist so bemessen, daß die Symmetrieachse 29 der Vertiefung 21 unmittelbar vor dem Anschlag der Schaltkugel 3 auf der Innenwand 28 der Vertiefung die Schaltkugel unmittelbar oberhalb ihres Mittelpunktes M' durchläuft und die Schaltkugel 3 mit ihrer Kugelfläche kreisförmig auf einem vom Außenrand der Vertiefung entfernten Kreis 30 der Innenwand 28 der Vertiefung 21.1 auflagert. Dadurch ist gewährleistet, daß der Lichtfluß durch die Vertiefung nicht nur spaltförmig, sondern über einen ausgedehnten Kanal um die Anlagestelle herum abgedichtet ist. Dadurch wird eine wesentlich günstigere Lichtabdichtung als bei einer spaltförmigen Lichtabdeckung erreicht.

Ein noch längerer Lichtabdichtungskanal wird erreicht, wenn die rotationssymmetrische Vertiefung in der Seitenwand kugelschalenförmig ausgebildet ist, wie dies in Figur 2 als weiteres Ausführungsbeispiel für die linksseitige rotationssymmetrische Vertiefung 21.4 dargestellt ist. Der Innendurchmesser der Kugelschale ist nur wenig größer als der Durchmesser der Schaltkugel 3, sodaß einerseits ein verhältnismäßig langer Kanal für die Lichtabdichtung entsteht und andererseits vermieden wird, daß die Schaltkugel in einer derartigen Endlagerstelle klemmt. Die Auflagerstellen der Schaltkugel in den einzelnen Vertiefungen 21 der Seitenwände 14 werden hier als Endlagerstellen 30 der Schaltkugel 3 bezeichnet, da diese Lagerstellen am Ende der möglichen Rollbahnen der Schaltkugel liegen.

Innerhalb des Innenraumes 6 des Kugelführungsgehäuses 1 sind zwischen jeweils zwei benachbarten Endlagerstellen 30 Abweiskanten 31 ausgebildet, die verhindern, daß die Schaltkugel 3 eine stabile Lage zwischen zwei benachbarten Endlagerstellen einnimmt.

In Figur 2 ist außerdem schematisch ein am Deckel 2 des Kugelführungsgehäuses 1 befestigter Federarm 32 dargestellt, dessen freies Ende einen Rasthaken 33 zur Befestigung des Kugelschalters auf einer nicht näher dargestellten Schaltungsplatte enthält. Außerdem ist in dem in Figur 2 dargestellten Ausführungsbeispiel die Innenseite des Deckels 2 ebenfalls als Basisebene ausgebildet und in den Deckel eine zweite pyramidenförmige Vertiefung 8' mit einer daran anschließenden kreisrunden Ausnehmung 11' angebracht, die vollständig der pyramidenförmigen Vertiefung 8 mit der daran anschließenden kreisförmigen Ausnehmung 11 im Boden 10 des Kugelführungsgehäuses 1 entspricht. Das hat den Vorteil, daß der in Figur 2 dargestellte Kugelschalter sowohl in aufliegender als auch in hängender Lage ohne zusätzliche Maßnahmen verwendet werden kann.

Sämtliche für den Kugelschalter erforderlichen Lichtsender- und Lichtempfängerelemente sind in den an die Seitenwände 14 des Kugelführungsgehäuses angebrachten Kammern 15 angeordnet. Dadurch ist gewährleistet, daß sämtliche Lichtelemente 16 und 17 den gleichen günstigen Lichtabdichtungsmaßnahmen unterworfen sind.

**Patentansprüche**

1. Kugelschalter zur signalmäßigen Kennzeichnung von auswählbaren Neigungsrichtungen einer Basisebene
   - mit einem die Basisebene (5) enthaltenden Kugelführungsgehäuse (1) und einer in der Basisebene angeordneten pyramidenförmigen Vertiefung (8), deren Pyramidenspitze (9) in Richtung der Schwerkraft (7) weist, die ferner eine den Auskippwinkel (a) der Schaltkugel (3) des Kugelschalters bestimmende Basislagerstelle (4) der Schaltkugel enthält und die mit der Basisebene ein Basislinienpolygon (27) bildet, dessen Ecken (26) in die Richtung der die ausgewählte Neigungsrichtung kennzeichnenden, eine Schalterstellung des Kugelschalters bildende Endlagerstellen der Schaltkugel weisen,
   - und mit Lichtsende- und Lichtempfangselementen (16, 17), die an den Endlagerstellen der Schaltkugel so angeordnet sind, daß sie gegen den Innenraum (6) des Kugelführungsgehäuses lichtdicht abgedeckt sind, wenn die Schaltkugel in der zugehörigen Lagerstellung gelagert ist,

   **dadurch gekennzeichnet**, daß die Endlagerstellen der Schaltkugel (3) kreisförmige Lagerstellen (30) von die Schaltkugel weniger als zur Hälfte aufnehmende, rotationssymmetrische, sich verjüngende Vertiefungen (21) in einer sich auf der Basisebene (5) erhebenden Seitenwand (14) des Innenraumes (6) des Kugelführungsgehäuses (1) sind, die so bemessen sind, daß deren Symmetrieachse (29) die auf der zugehörigen Ecke (26.1) des Basislinienpolygons (27) auflaufende Schaltkugel unmittelbar oberhalb deren Mittelpunkt (M') durchläuft, und von denen jede Vertiefung (21) über eine in den Grund der Vertiefung mündende Bohrung (20) mit einer nur dieser Vertiefung zugeordneten, im übrigen lichtdichten Kammer (15) verbunden ist, in der eines der Lichtsenderelemente (16) oder der Lichtempfängerelemente (17) angeordnet ist.

2. Kugelschalter nach Anspruch 1,
   **dadurch gekennzeichnet,** daß die rotationssymmetrischen Vertiefungen (21.4) kugelförmig sind, deren Kugelschale weniger als einen halben Raumwinkel umfaßt und einen Durchmesser aufweist, der nur wenig größer ist als der der Schaltkugel (3).

3. Kugelschalter nach Anspruch 1,
   **dadurch gekennzeichnet**, daß die rotationssymmetrische Vertiefung (21.1) kegelförmig ist, und daß in die Kegelspitze dieser Vertiefung die Bohrung (20) von der Kammer (15.1) des zugehörigen Lichtelementes (17.1) mündet.

4. Kugelschalter nach einem der Ansprüche 1 bis 3,
   **dadurch gekennzeichnet**, daß sowohl der Boden (10) als auch der Deckel (2) des Kugelführungsgehäuses (1) eine Basisebene (5, 5') mit einer pyramidenförmigen Vertiefung (8, 8') enthält.

5. Kugelschalter nach einem der Ansprüche 1 bis 4,
   **dadurch gekennzeichnet**, daß alle Lichtsender- und Lichtempfängerelemente (16, 17) in den Vertiefungen (21) der Endlagerstellen (30) zugeordneten Kammern (15) angeordnet sind.

Fig. 1

Fig. 2

Fig. 3

Europäisches
Patentamt

# EUROPÄISCHER RECHERCHENBERICHT

Nummer der Anmeldung

EP    92 10 7230

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| D,A | DE-A-3 924 551 (NOKIA UNTERHALTUNGSELEKTRONIK GMBH) <br> * Zusammenfassung * <br> * Spalte 10, Zeile 11 - Zeile 30; Abbildungen 7-9 * <br> --- | 1 | H03K17/968 <br> H01H35/02 |
| A | EP-A-0 287 107 (H. RUF GMBH & CO,KG) <br> * Spalte 5, Zeile 10 - Zeile 35; Abbildung 6 * <br> --- | 1 | |
| D,A | DE-U-8 908 132 (K. HELLMUTH JUN.) <br> * Ansprüche 1-3; Abbildungen 1,7 * <br> --- | 1 | |
| P,A | FUNKSCHAU <br> Nr. 17, 9. August 1991, MüNCHEN <br> Seiten 62 - 63; 'einstellungen aus dem handgelenk' <br><br> ----- | 1 | |

|  |  |
|---|---|
|  | RECHERCHIERTE SACHGEBIETE (Int. Cl.5 ) |
|  | H03K <br> H01H <br> G08C <br> G02B |

Der vorliegende Recherchenbericht wurde für alle Patentansprüche erstellt

| Recherchenort | Abschlußdatum der Recherche | Prüfer |
|---|---|---|
| BERLIN | 10 AUGUST 1992 | RUPPERT W. |